# EUROPEAN PATENT APPLICATION

(11) **EP 0 568 341 A2**
(43) Date of publication of application: **03.11.1993**
(21) Application number: 93303316.9
(22) Date of filing: 28.04.1993
(51) Int. Cl.: H01L 27/02

(54) **Electrostatic discharge protection structure**

(30) Priority: 30.04.1992 US 876256
(71) Applicant: TEXAS INSTRUMENTS INCORPORATED, Dallas Texas 75265 (US)
(72) Inventor: Carbajal III, Bernard G., Richardson, Texas 75080 (US); Chatterjee, Amitava, Plano, Texas 75023 (US); Cline, Roger A., Plano, Texas 75025 (US); Polgreen, Thomas L., Dallas, Texas 75229 (US)
(74) Representative: Blanco White, Henry Nicholas

(57) **Abstract**

A protection structure (15) for protecting electrostatically sensitive electrical circuits from ESD includes an SCR (17), and an n-well or p-well resistor (19) which is connectable between the SCR (17) and the electrostatically sensitive circuit (11).

## Description

### FIELD OF THE INVENTION

The present invention relates to circuitry for protecting sensitive electronic devices from damage due to overvoltage conditions and, more particularly, to an improved electrostatic discharge (ESD) protection structure.

### BACKGROUND OF THE INVENTION

ESD protection circuitry is essential for modern integrated circuits. In particular, integrated circuits which are based on field effect transistors are very sensitive to the high voltages which may be generated by the electrostatic discharge developed in the human body. During installation of such integrated circuits into products, they may be destroyed by ESD, thus requiring replacement of the destroyed integrated circuits in the fully assembled product, which replacement is generally a costly and tedious process. The damaging effect of ESD is particularly acute in complimentary metal oxide semiconductor (CMOS) integrated circuits. Extremely high ESD voltages can easily destroy the very thin gate oxides and very short channel devices of typical CMOS integrated circuits.

Some known ESD protection circuits use a silicon controlled rectifier (SCR) as the ESD protection element. U.S. Patent Number 4,939,616, assigned to the assignee of this application and incorporated herein by reference, discloses one example of an SCR used as an ESD protection element. The SCR used in that patent is illustrated in Figures 2-4 of the present application.

Another example of a known ESD protection structure is disclosed in "A Low-Voltage Triggering SCR for On-Chip ESD Protection at Output and Input Pads", by A. Chatterjee and T. Polgreen, which is incorporated herein by reference and which was published in IEEE Electron Device Letters, Vol. 12, #1, January 1991. Figures 5-7 of the present application illustrate the SCR structure used in that publication.

The aforementioned conventional ESD protection circuits can provide protection against ESD damage. However, they do not reproducibly provide effective ESD immunity beyond 2KV (human body model). The industry target is to achieve ESD immunity greater than 2KV.

It is therefore desirable to provide an ESD protection structure which reproducibly gives an increased level of ESD immunity.

In addition, it is difficult to ensure that the SCR will trigger before the ESD event damages the protected circuit. It is therefore desirable to provide an ESD protection structure which reproducibly causes the SCR to trigger during an ESD event before the protected circuit is damaged.

SCRs have been combined with diffusion resistors and polysilicon resistors to protect CMOS inputs, as discussed in "A Synthesis of ESD Input Protection Scheme", by Charvaka Duvvury and Robert Rountree, 1991 EOS/ESD Symposium Proceedings, pp 88-97, incorporated herein by reference. However, this structure has not been used to protect CMOS outputs against ESD.

It is therefore desirable to provide an ESD protection structure which can effectively protect any designated circuit structure, regardless of whether that circuit structure is an input structure, an output structure, or a bidirectional structure.

According to the present invention, a protection structure is provided to protect electrostatically sensitive electrical circuits and provide greater ESD immunity than the prior art. The ESD protection structure includes an SCR, and an n-well or p-well resistor arrangement between the SCR and the electrostatically sensitive circuit.

The present invention also demonstrates how the resistor values may be chosen to provide adequate ESD isolation and meet the circuit input and output specifications, and how the lateral bipolar design dimensions of the SCR may be optimized to compensate for the parasitic vertical bipolar transistor that is inherent in the CMOS process.

### BRIEF DESCRIPTION OF THE DRAWINGS

Exemplary embodiments of the present invention are described below in conjunction with the attached drawings, wherein:
Figure 1 is a block diagram of an integrated circuit incorporating the ESD protection structure according to the present invention;
Figure 1A illustrates the ESD protection structure of Figure 1 applied to an input circuit structure;
Figure 1B illustrates the ESD protection structure of Figure 1 applied to an output circuit structure;
Figure 1C illustrates the ESD protection structure of Figure 1 applied to a bidirectional circuit structure;
Figure 2 is a cross-sectional diagram of a prior art SCR which may be used in the integrated circuit of Figure 1;
Figure 3 is a plan view of the SCR of Figure 2;
Figure 4 is an equivalent circuit diagram of the SCR of Figure 2;
Figure 5 is a cross-sectional diagram of another prior art SCR which may alternatively be used in the integrated circuit of Figure 1;
Figure 6 is a plan view of the SCR of Figure 5;
Figure 7 is an equivalent circuit diagram of the SCR of Figure 5;
Figure 8 is a cross-sectional diagram of the n-well resistor arrangement of Figure 1B;
Figure 8A is a cross-sectional diagram of the n-well resistor arrangement of Figure 1A;
Figure 9 is a plan view of a prior art n-well resistor used in the present invention; and
Figure 10 is a cross-sectional view which illustrates the breakdown mode of a conventional output structure when subjected to ESD without protection.

### DETAILED DESCRIPTION

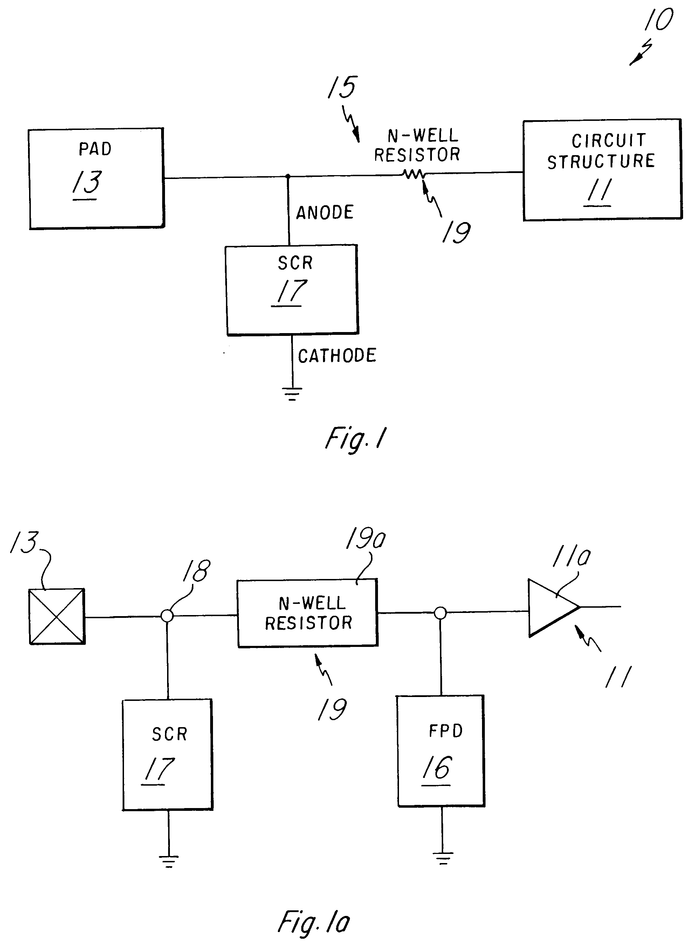

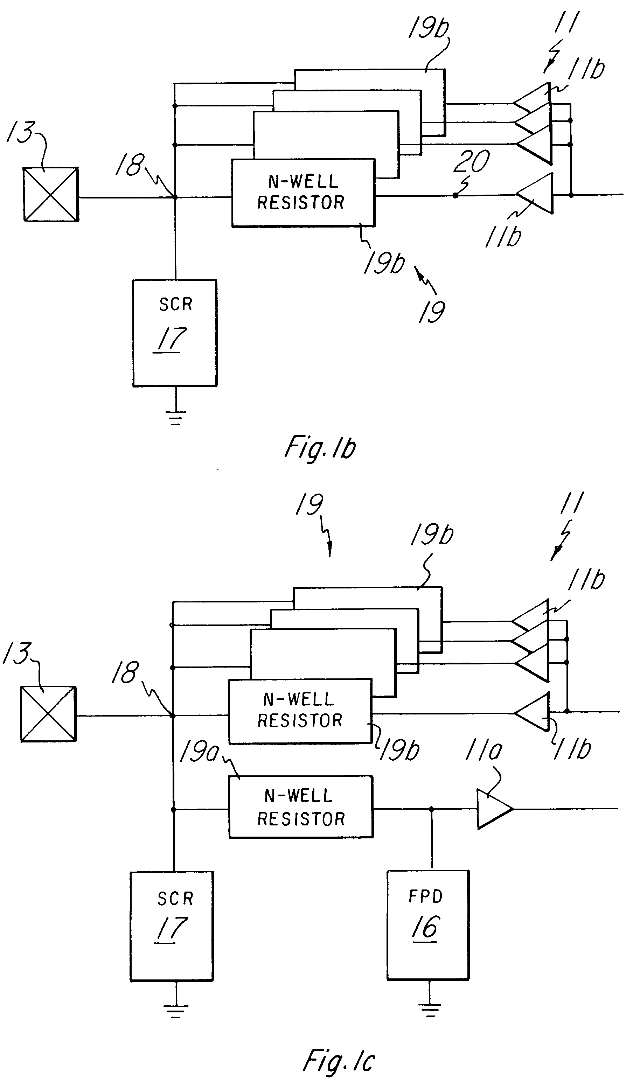

Figure 1 illustrates an integrated circuit 10 which incorporates the ESD protection structure according to the present invention. The integrated circuit 10 includes circuit structure 11 which represents the functional operating circuit of the integrated circuit 10. In the embodiment illustrated in Figure 1, the ESD protection structure 15 is interposed between the circuit structure 11 and the contact pad 13 of the integrated circuit 10.

The ESD protection structure 15 is a circuit which includes an SCR 17 having its cathode grounded and having its anode connected to the contact pad 13, and an n-well resistor 19 having a first node connected to the anode of the SCR 17 and having a second node connected to the circuit structure 11.

Figures 1A, 1B, and 1C respectively illustrate the ESD protection structure of Figure 1 as applied to an input structure, an output structure, and a bidirectional structure. These drawings are discussed in more detail below.

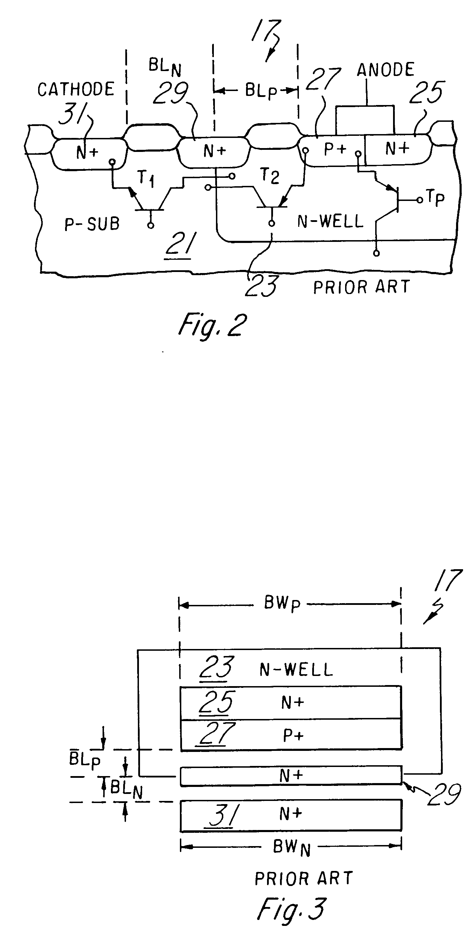

Figures 2-4 illustrate one embodiment of the SCR 17 used in the present invention. As noted above, the SCR structure of Figures 2-4 is conventional and will therefore be familiar to those skilled in the art. Figure 2 is a cross sectional diagram of the SCR 17. The SCR 17 is formed in a silicon semiconductor substrate 21 which is lightly doped p-type. A lightly doped n-well 23 is formed in the substrate 21. Heavily doped n-type region 25 and the adjacent heavily doped p-type region 27 are formed in the n-well 23. These regions 25 and 27 (often referred to as moats) represent the anode of the SCR 17, and are electrically connected to the contact pad 13. Heavily doped n-type region 29 is disposed at the interface between the n-well 23 and the p-substrate 21, which interface is laterally spaced from heavily doped p-type region 27 by a distance BLp. Heavily doped n-type region 31, formed in p-substrate 21, is laterally spaced from the n-well 23 by a distance BLn and functions as the cathode of the SCR 17.

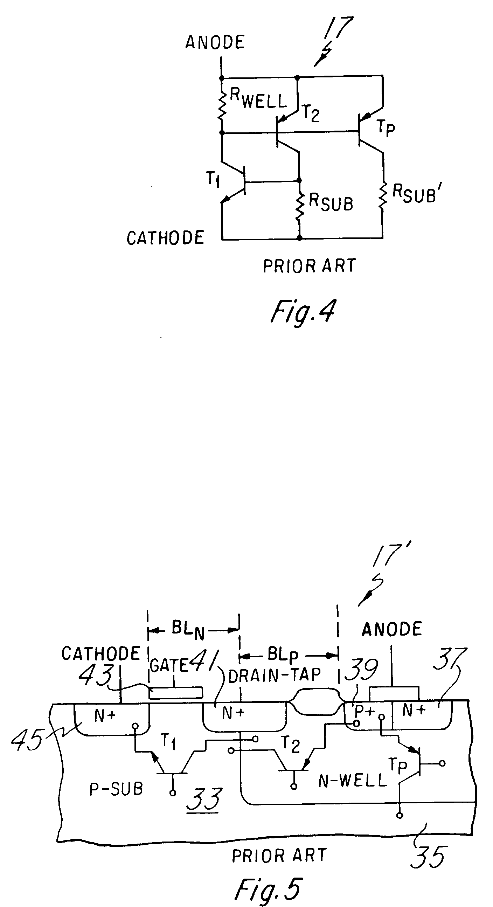

Referring also to Figure 4, the npn transistor T₁ of SCR 17 has a collector provided by the n-well 23, a base provided by the p-substrate 21, and an emitter provided by the heavily doped n-type region 31. The pnp transistor T₂ has a collector provided by the p-substrate 21, a base provided by the n-well 23, and an emitter provided by the heavily doped p-type region 27. The resistor R_{well} is provided by the resistive nature of the lightly doped n-well 23 extending from heavily doped n-type region 25. The resistor R_{sub} is provided by the resistance of the p-substrate 21.

In addition to the so-called lateral transistors T₁ and T₂, the SCR 17 also includes a parasitic vertical pnp transistor Tₚ (Figures 2 and 4) having a collector provided by the p-substrate 21, a base provided by the n-well 23, and an emitter provided by the heavily doped p-type region 27. R_{sub}' in Figure 4 is provided by the resistance of the p-substrate 21. Parasitic vertical pnp transistor Tₚ is disposed in parallel with the lateral pnp transistor T₂. The lateral and vertical geometries of the SCR 17 must be ratioed such that the lateral pnp transistor T₂ and the lateral npn transistor T₁ will interact to provide effective SCR action without adverse effects from the parasitic vertical pnp transistor Tₚ. In this regard, the vertical dimensions of the regions 21, 23, 25, 27, 29 and 31 are determined by the process flow used to produce the SCR. Thus, the characteristics of the parasitic vertical pnp transistor Tₚ are determined by the process flow being used. Therefore, the adverse effects of Tₚ must be compensated for by appropriately designing the characteristics of the lateral transistors T₁ and T₂. The lateral spacing BLp is the design parameter for the lateral pnp transistor T₂, and the lateral spacing BLn is the design parameter for the lateral npn transistor T₁. When the lateral spacings BLp and BLn are selected properly, the adverse effects of Tₚ can be reduced, resulting in effective SCR action.

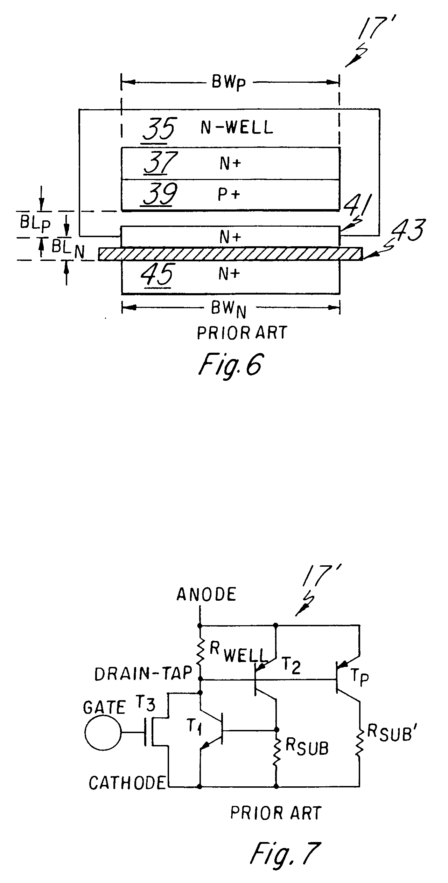

Figures 5-7 illustrate another example of a conventional SCR which may be used in the ESD protection structure of Figure 1. The SCR 17' of Figures 5-7 is similar to that of Figures 2-4, except that a field effect transistor T₃ has been added as illustrated in Figure 7. Referring now to Figure 5, the regions 33, 35, 37, 39, 41 and 45 operate in the same manner as regions 21, 23, 25, 27, 29 and 31 of Figure 2. The SCR 17' of Figure 5 differs from the SCR 17 of Figure 2 in that a poly gate 43 has been provided between regions 41 and 45 to thereby produce the field effect transistor T₃ of Figure 7. The length of poly gate 43 should be equivalent to the length of the poly gates used in the circuit structure 11 of Figure 1.

As an illustrative example, if a 1.0 micron high performance CMOS process flow is used to produce the integrated circuit 10 of Figure 1, then the regions 25, 27, 29 and 31 of Figures 2-4 (or the corresponding regions 37, 39, 41 and 45 of Figures 5-7) have a vertical dimension of approximately 0.3 microns, the vertical dimension of the n-well 23 (or 35) is approximately 2.5 microns, and the vertical dimension of the p-substrate 21 (or 33) is approximately 6.5 microns. With these vertical parameters as fixed by the process flow, the Applicants have determined that, for each SCR 17 (Figures 2-4) and 17' (Figures 5-7), the lateral spacings BLp and BLn should each be approximately 2.4 microns in order to compensate adequately for the effects of parasitic pnp transistor Tₚ and provide effective SCR performance. Thus, effective SCR performance has been obtained when the lateral spacings BLp and BLn are approximately equal to the vertical dimension (i.e. the depth) of the n-well.

The SCR 17 of Figures 2-4 typically triggers in the range of 20-30 volts. The trigger voltage is controlled by the breakdown of n+ region 29 to the substrate 21. If the lateral dimensions, BLp and BLn are properly controlled, the ability of the SCR to dissipate several watts of power during an ESD event is controlled by the width, BWp and BWn of the SCR. BWp and BWn are 100 microns in the disclosed embodiments. However, these dimensions can be set as needed to dissipate the desired amount of power, as is well known in the art. Thus the SCR can be designed to be effective for ESD events greater than 2KV. However, if the electrostatically sensitive circuit elements in circuit structure 11 breakdown before the SCR trigger voltage is reached, the SCR 17 will not provide circuit protection during an ESD event.

The SCR 17' of Figures 5-7 typically triggers in the range of 10-14 volts when fabricated on the aforementioned 1.0 micron high performance CMOS process flow. The trigger voltage is controlled by the BVdss of the field effect transistor T₃. As in SCR 17, if the lateral dimensions, BLp and BLn are properly controlled, the ability of the SCR 17' to dissipate several watts of power during an ESD event is controlled by the width, BWp and BWn of the SCR. Thus the SCR 17' can be designed to be effective for ESD events greater than 2KV. Again, if the electrostatically sensitive circuit elements breakdown before the SCR trigger voltage is reached, the SCR 17' will not provide circuit protection during an ESD event.

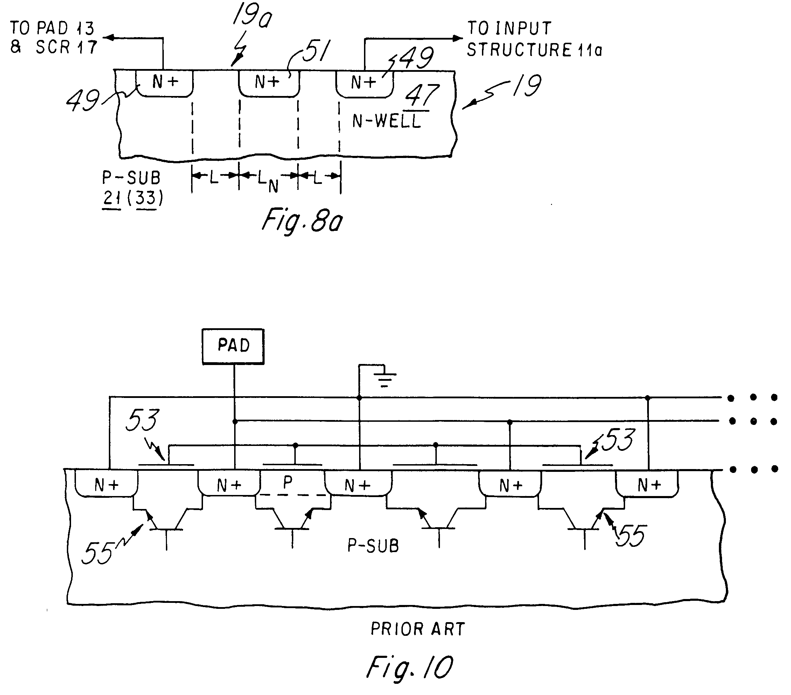

Figure 10, illustrates output n-channel transistors 53 produced by the aforementioned 1.0 micron high performance CMOS process. The n-channel transistors 53 have a breakdown voltage, BVdss, in the range of 10-14 volts. Parasitic npn bipolar transistors 55 exist in parallel with the n-channel transistors 53. At breakdown, one of the parasitic npn bipolar transistors 55 will go into snap back, causing the applied voltage to decrease. As the applied power increases, the npn transistor goes from snap back into secondary breakdown, and the power is localized along a secondary breakdown path P, causing the npn transistor to self destruct. This is the typical failure mode of n-channel transistors when too much voltage is applied to the drain regions.

In the case of a CMOS output transistor, the interdigitated drain region has many parallel n-channel transistors 53 and their parasitic npn bipolar counterparts 55. A breakdown by any of the interdigitated regions will cause the applied voltage to decrease and focus the power into the localized secondary breakdown region P. Since the breakdown voltage of the n-channel transistors 53 is equivalent to the trigger voltage of the SCR 17' and significantly lower than the trigger voltage of SCR 17, neither of these SCRs alone will provide consistent ESD protection to a CMOS circuit. More specifically, there is no guarantee that SCR 17' will trigger soon enough to protect the circuit structure, while SCR 17 will never trigger soon enough to provide protection.

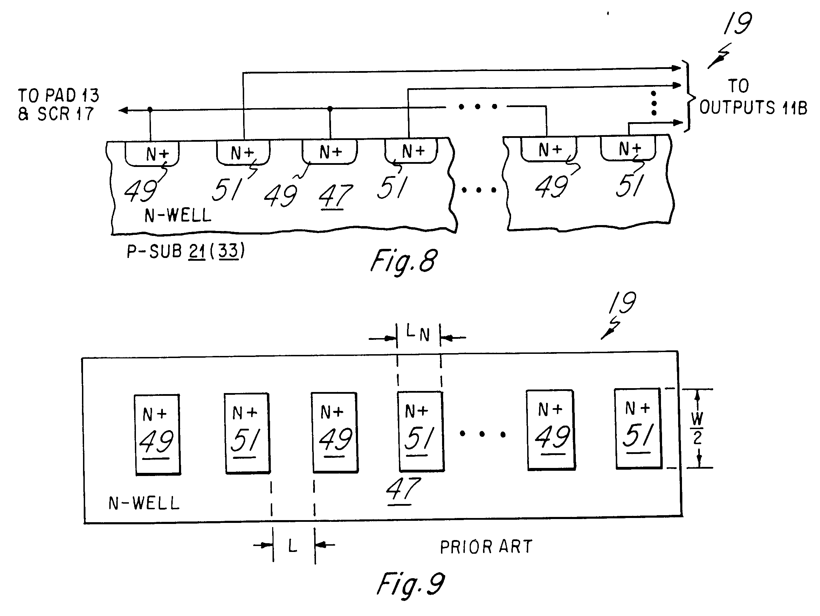

As shown in Figures 8-9, the n-well resistor 19 has a plurality of heavily doped n-type regions 49 and 51 arranged in parallel along the length of a lightly doped n-well 47. The n-well 47 is provided in the p-substrate 21 (or 33). The n-well resistor per se is known in the art and should therefore be familiar to those skilled in the art (see e. g., G. Krieger and P. Niles, "Diffused Resistors Characteristics at High Current Density Levels - Analysis and Applications", IEEE Trans. Elec. Dev., Vol. 36, No. 2, p. 416, 1989). Figure 8 illustrates the connection scheme used in conjunction with the output structure of Figure 1B. Alternate ones of the n-type regions represented by 49 are connected together and to the pad 13 and SCR 17. The remaining alternate n-type regions 51 are separately connected to the respective output components 11B in order to realize the separate resistors 19B of Figure 1B.

In the disclosed embodiments using the aforementioned 1.0 micron high performance CMOS process flow, the vertical dimension of the n-well 47 (that is, the n-well depth) is approximately 2.5 microns, while the vertical dimension of the n-type regions 49 and 51 is approximately 0.3 microns. The sheet resistance is approximately 1800 ohms/square. This n-well resistor is used to ensure that the SCR will trigger before secondary breakdown of the electrostatically sensitive circuit structure.

Referring to Figure 1B, the value of resistors 19B is chosen to generate an acceptably small voltage drop at the rated current of the output structure 11. For example, with a rated output current of 16 milliamps, if a 100 millivolt drop is desired, then the equivalent resistance between node 18 and output structure 11 should be 6.25 ohms. Because there are four resistors 19B in the resistor array of Figure 1B, the resistance value of each resistor 19B should be 25 ohms in order to realize the desired equivalent parallel resistance of 6.25 ohms. Given the aforementioned sheet resistance of 1800 ohms/square, the desired 25 ohm resistors can be realized by the arrangement illustrated in Figures 8-9. More specifically, if the length dimension L is 2 microns and the width dimension W/2 is 70 microns, then the connection scheme illustrated in Figure 8 produces a plurality of resistors each having a length-to-width ratio of 2/140, thereby providing a resistance of about 25 ohms each. The ratio of 2/140 results because the alternate n-type regions 49 are connected together and to the SCR, so that each of the n-type regions 51 is associated with two of the regions 49, giving each of the resistors an effective width which is twice the width W/2 shown in Figure 9, that is, 2 x 70 = 140 microns.

Referring again to Figure 1B, it should be noted that the individual outputs 11B can be expected to draw approximately equal amounts of current, about 4 milliamps each in the disclosed example. That is, the output components 11B contribute about equally to the total rated output current of 16 milliamps. The output protection structure of Figure 1B can be easily extended to other output configurations in the following manner. As an example, if a fifth output is added in Figure 1B, the output current increases to 20 milliamps. By adding a fifth 25 ohm resistor between this fifth output and node 18, the equivalent resistance between node 18 and output structure 11 is reduced to 5 ohms, which provides a 100 millivolt drop at the rated current of 20 milliamps. Thus, by providing a separate resistor 19B for each output 11B, the desired ESD protection is provided for any given number of outputs 11B while also maintaining the desired voltage drop during normal operation.

Referring now to Figure 1A, the value of the resistor 19A used in conjunction with the input structure 11 should be in the range of 100-250 ohms. A 167 ohm resistor is obtained by connecting the n-well resistor 19 of Figure 9 in the manner illustrated in Figure 8A. The n-type regions of Figure 9 have a length Lₙ of approximately 2.5 microns. Thus, given that L is 2 microns and W/2 is 70 microns, the length-to-width ratio of the resistor illustrated in Figure 8A is 6.5/70.

Based on the above descriptions of SCR 17, SCR 17', n-channel transistor breakdown characteristics and resistor ranges, one can see how the ESD protect structure according to the invention will work on a CMOS output, Figure 1B. During an ESD event the voltage on pad 13 begins to rise and a breakdown occurs in the range of 10-14 volts. As an example, if initial breakdown occurs in one of the n-channel transistors, then the snap back current must flow through the corresponding resistor 19B. A voltage drop is generated across the resistor 19B as current flows into the n-channel transistor, causing the voltage at node 18 to be higher than the voltage at node 20. The n-well resistor restricts the amount of current that can flow and prevents the parasitic npn transistor from going into the secondary breakdown region. The n-well resistor is particularly well suited to restrict current flow due to its relatively flat I-V curve at higher voltages. As the voltage at node 18 rises to exceed the trigger voltage of the SCR 17 (or SCR 17'), the power of the ESD event is discharged through the SCR to ground with no resultant damage to the output structure at 11B.

When SCR 17' of Figures 5-7 is used, it is possible for initial breakdown to occur in the SCR 17' instead of the n-channel transistor, in which case the SCR 17' safely dissipates the power of the ESD event without damage to the protected circuit structure. The SCR 17 of Figures 2-4 has a trigger voltage in the range of 20-30 volts, and therefore would never trigger before breakdown of the n-channel transistor.

Based on the above descriptions of SCR 17, SCR 17', and resistor ranges, one can see how the ESD protect structure will work on a CMOS input as shown in Figure 1A. The field plated diode (FPD) 16, also known as a gated diode, has been included in the input protection structure of Figure 1A. The FPD 16, a conventional input protection device having a breakdown voltage in the range of 10-14 volts, protects the thin gate oxide from damaging voltages. During an ESD event, when the voltage across FPD 16 reaches the breakdown voltage of FPD 16, the current drawn by FPD 16 through n-well resistor 19A causes the voltage at node 18 to rise. This situation is analogous to the snap back phase of output protection discussed above. In the case of SCR 17', the description of output protection above describes the sequence of possible events. The case for SCR 17 is also described above. The resistor value for resistor 19A as used with the input structure 11A is in the range of 100-250 ohms.

A bidirectional pin is a combination of a standard input and a three-state output. The ESD protect circuit, shown in Figure 1C, is a combination of a single SCR 17 (or SCR 17') and the appropriate input resistor 19A and output resistor array 19B as described above. All of the resistors 19A and 19B can be realized using a single n-well 47 (Figure 9) and the connections shown in Figures 8 and 8A. The power of the ESD event is discharged to ground through the SCR 17 (or SCR 17') with no resultant damage to the input structure 11A or the output structure 11B.

The ESD protection structure described above will reproducibly provide consistent ESD immunity to ESD events greater than 2KV in magnitude. In fact, using either the SCR of Figures 2-4 or the SCR of Figures 5-7 in conjunction with the resistor of Figures 8-9, ESD immunity of over 4KV has been successfully demonstrated. This 4KV level far exceeds the ESD immunity available using the SCRs of Figures 2-4 or Figures 5-7 alone. Moreover, the ESD protection structure according to the present invention is independent of the resistance of the heavily doped p+ and n+ regions and can be used with normal and low resistance n+ and p+ regions. The ESD protection structure of the present invention can be used for all types of inputs, outputs and bidirectional structures, and can be used with processes other than the aforementioned 1.0 micron high performance CMOS process. Of course, if a different process flow is used, it would likely be necessary to adjust the values of the lateral spacings BLp and BLn of the SCR in order to achieve acceptable lateral pnp transistor versus parasitic vertical pnp transistor performance.

Although specific embodiments of the present invention are disclosed above in detail, they are not to be construed as limiting the scope of the invention. Many variations and modifications of the disclosed embodiments will be apparent to those skilled in the art. As examples, the invention can clearly use SCR structures other than those disclosed above, and it is clearly within the scope of the invention to change the doping polarities so that the components of ESD protection structure 15 are constructed using a p-well in an n-substrate. Thus, the present invention is only limited by the scope of the attached claims.

## Claims

1. An integrated circuit having an electrostatic discharge protection feature, comprising:
a primary functional circuit; and
a protection structure connected to said primary functional circuit for protecting said primary functional circuit from electrostatic discharge, said protection structure including an SCR and a resistor connected in series between said SCR and said primary functional circuit.

2. An integrated circuit according to claim 1, wherein said SCR has an anode and a cathode, said cathode being fixed to a known electrical potential, and said resistor is an n-well resistor having a first node connected to said anode and a second node connected to said primary functional circuit.

3. An integrated circuit according to claim 2, wherein said primary functional circuit has an output transistor which is connected to said second node of said n-well resistor.

4. An integrated circuit according to any preceding claim, wherein said primary functional circuit is a CMOS circuit.

5. An integrated circuit according to any preceding claim, wherein said primary functional circuit includes a plurality of output components, said protection structure including a plurality of said resistors adapted so that each said resistor is uniquely associated with a respective output component and provides a dedicated resistive connection between the respective output component and the SCR.

6. An integrated circuit according to claim 5, wherein said plurality of resistors are formed from a row of relatively heavily doped n-type regions disposed within a relatively lightly doped n-well, said first nodes being respectively defined by alternate ones of said n-type regions, said alternate regions being connected together and to said SCR, said second nodes being respectively defined by the remainder of said n-type regions.

7. An integrated circuit according to claim 5 or claim 6, wherein said primary functional circuit includes an input circuit structure, said protection structure including a further n-well resistor having a first node connected to said SCR and a second node connected to said input circuit structure, and means connected to said second node of said further n-well resistor for selectively permitting current to flow through said further n-well resistor toward said second node thereof, said first and second nodes of said further n-well resistor being respectively defined by a pair of further relatively heavily doped n-type regions within said n-well.

8. An integrated circuit according to claim 7, wherein said means for permitting current flow is a field plated diode.

9. An integrated circuit according to any preceding claim, wherein said SCR includes a relatively lightly doped substrate having a first conductivity type, a relatively lightly doped first region disposed within said substrate and having a second conductivity type, a relatively heavily doped second region disposed within said first region and having said first conductivity type, and a relatively heavily doped third region disposed within said substrate but outside of said first region, said third region having said second conductivity type and being laterally spaced from said first and second regions, said first region having a depth of penetration into said substrate, said first region and said substrate adjoining each other along an interface disposed laterally between said second and third regions, said second and third regions each being laterally spaced from said interface by a distance which is approximately equal to said depth of said first region.

10. A protection structure for protecting an eletrostatically sensitive electrical circuit from electrostatic discharge, comprising:
an SCR; and
a resistor arrangement having a first node connected to said SCR and a second node which is connectable to the electrostatically sensitive circuit.

11. A protection structure according to claim 10, wherein said resistor arrangement including one of an n-well resistor in a p-substrate and a p-well resistor in an n-substrate.

12. A protection structure according to claim 10 or claim 11, wherein said SCR includes a relatively lightly doped substrate having a first conductivity type, a relatively lightly doped first region disposed within said substrate and having a second conductivity type, a relatively heavily doped second region disposed within said first region and having said first conductivity type, and a relatively heavily doped third region disposed within said substrate but outside of said first region, said third region having said second conductivity type and being laterally spaced from said first and second regions, said first region having a depth of penetration into said substrate, said first region and said substrate adjoining each other along an interface disposed laterally between said second and third regions, said second and third regions each being laterally spaced from said interface by a distance which is approximately equal to said depth of said first region.
